# EUROPEAN PATENT APPLICATION

(11) **EP 4 765 575 A1**
(43) Date of publication of application: **24.06.2026**
(21) Application number: 25219806.4
(22) Date of filing: 01.12.2025
(51) Int. Cl.: H02J 7/60, B60L 3/04, G01R 31/00, G01R 31/327, H01H 39/00

(54) **PYROFUSE IGNITION APPARATUS AND BATTERY SYSTEM INCLUDING PYROFUSE**

(30) Priority: 18.12.2024 KR 20240190599
(71) Applicant: SAMSUNG SDI CO., LTD., Yongin-si, Gyeonggi-do 17084 (KR)
(72) Inventor: CHO, Kyusung, 17084 Yongin-si, Gyeonggi-do (KR)
(74) Representative: Gulde & Partner

(57) **Abstract**

According to an aspect of the present disclosure, there is provided a pyrofuse ignition apparatus (100) including a pyroswitch (88) including a high side (87) to which an operating voltage is applied, a low side (89) to which a ground is connected, and an internal resistance (Rp) between the high side (87) and the low side (89), a low side switch (110) that outputs an ignition start signal (112) to the low side of the pyroswitch, a constant current supplier (120) that is connected to the low side of the pyroswitch and supplies a constant current to the internal resistance of the pyroswitch (Rp), a high side switch (130) configured to turn off an operating voltage applied to the high side of the pyroswitch when diagnosing the pyroswitch (88), and a resistance monitoring unit (140) configured to monitor a voltage difference across the internal resistance of the pyroswitch (Rp).

## Description

### FIELD

The present disclosure relates to a battery system including a pyrofuse applied to battery modules/packs, energy storage systems (ESSs), or electric vehicles, and a pyrofuse ignition apparatus.

### BACKGROUND

Different from primary batteries that are not designed to be charged, secondary batteries are designed to be discharged and recharged. Low-capacity secondary batteries are used in small portable electronic devices, such as smart phones, feature phones, notebook computers, digital cameras, and camcorders, while large-capacity secondary batteries are widely used as power sources for driving motors and power storage in hybrid vehicles or electric vehicles. The secondary battery includes an electrode assembly composed of a positive electrode and a negative electrode, a case that accommodates the electrode assembly, a terminal connected to the electrode assembly, etc.

A battery module/pack, an energy storage system (ESS), or an electric vehicle in which multiple batteries are combined to increase voltage and/or current capacity may include a battery management system (BMS). The BMS measures voltages (V), currents (I), temperatures (T), etc., of batteries installed in electric vehicles or the ESS through sensors, controls the batteries by checking the voltages, the currents, the temperatures, etc., in advance and exhibiting optimal performance, and provides various protection functions.

Meanwhile, since most electric vehicles use a high voltage of 300 V or higher, there can be a risk of electric shock and problems such as battery fire, explosions, current leakage, etc., which may occur in the event of a traffic collision. To prepare for these problems, a battery disconnection device or pyrofuse capable of securing safety by physically disconnecting the wiring through igniting explosives in the event of a vehicle accident is applied to vehicles.

As an ignition device for detonating an explosive of a pyrofuse, a switch circuit that simply applies high current to ignite the explosive of the pyrofuse has been used conventionally, and in a more advanced form, a diagnostic function for the pyrofuse is added to the ignition device.

The information disclosed herein in this Background section is for enhancement of understanding of the background of the present disclosure, and therefore, it may contain information that does not constitute a related art.

### SUMMARY

The present disclosure is directed to proposing a compact electronic circuit-based ignition apparatus that enhances diagnostic and monitoring functions of a pyrofuse, facilitates the control of an ignition function, and is relatively inexpensive.

According to aspects of the present disclosure, there is provided a pyrofuse ignition apparatus including a pyroswitch including a high side to which an operating voltage is applied, a low side to which a ground is connected, and an internal resistance between the high side and the low side, a low side switch that outputs an ignition start signal to the low side of the pyroswitch, a constant current supplier that is connected to the low side of the pyroswitch and supplies a constant current to the internal resistance of the pyroswitch, a high side switch configured to turn off an operating voltage applied to the high side of the pyroswitch when diagnosing the pyroswitch, and a resistance monitoring unit configured to monitor a voltage difference across the internal resistance of the pyroswitch.

According to aspects of the present disclosure, there is provided a battery system including a battery module including a plurality of battery cells, a pyroswitch configured to block charge/discharge paths of the battery module, an ignition apparatus configured to operate the pyroswitch, and a control unit configured to provide the ignition apparatus with a signal for monitoring a state of the pyroswitch and a signal for initiating ignition and receive a state detection signal of the pyroswitch from the ignition apparatus.

Aspects and features of the present disclosure are not limited to those described herein, and other aspects and features not specifically mentioned herein will be clearly understood by those skilled in the art from the description of the present disclosure herein.

According to aspects of the present disclosure, there is provided a method of manufacturing a pyrofuse ignition apparatus including providing a pyroswitch having a high side to which an operating voltage is applied, a low side to which a ground is connected, and an internal resistance between the high side and the low side, providing a low side switch that outputs an ignition start signal to the low side of the pyroswitch, providing a constant current supplier that is connected to the low side of the pyroswitch and supplies a constant current to the internal resistance of the pyroswitch, providing a high side switch configured to turn off an operating voltage applied to the high side of the pyroswitch when diagnosing the pyroswitch, and providing a resistance monitoring unit configured to monitor a voltage difference across the internal resistance of the pyroswitch.

### BRIEF DESCRIPTION OF THE DRAWINGS

The following drawings attached to the present specification show embodiments of the present disclosure and further describe aspects and features of the present disclosure together with the detailed description of the present disclosure. Thus, the present disclosure should not be construed as being limited to the drawings, in which:
FIG. 1 schematically shows a pouch-type secondary battery;
FIG. 2 is a cross-sectional view of a cylindrical secondary battery;
FIG. 3 is a cross-sectional view of a prismatic secondary battery;
FIG. 4 is an exemplary view of a secondary battery pack;
FIG. 5 is a view showing a vehicle in which the secondary battery pack is mounted;
FIG. 6 is a block diagram showing a vehicle including a battery system according to embodiments of the present disclosure;
FIG. 7 is a schematic configuration view of an ignition apparatus (100) according to some embodiments of the present disclosure;
FIG. 8A shows each part of the ignition apparatus (100) shown in FIG. 7 in more detail;
FIG. 8B is an exemplary circuit diagram implementing the configuration shown in FIG. 8A;
FIGS. 9A to 9D show a test simulation result of the pyroswitch ignition apparatus (100) according to the present disclosure; and
FIG. 10 shows a result of simulating the operation of a low side switch (110) of the pyroswitch ignition apparatus (100) according to the present disclosure.

### DETAILED DESCRIPTION

Hereinafter, embodiments of the present disclosure will be described, in detail, with reference to the accompanying drawings. The terms or words used in the present specification and claims are not to be narrowly interpreted according to their general or dictionary meanings and should be interpreted as having meanings and concepts that are consistent with the technical idea of the present disclosure on the basis of the principle that an inventor can be his/her own lexicographer to appropriately define concepts of terms to describe his/her disclosure in the best way.

The embodiments described in this specification and the configurations shown in the drawings are only some embodiments of the present disclosure and do not represent all of the aspects, features, and embodiments of the present disclosure. Accordingly, it should be understood that there may be various equivalents and modifications that can replace or modify one or more embodiments or features therein described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

References to two compared elements, features, etc. as being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

The terminology used herein is for the purpose of describing embodiments of the present disclosure and is not intended to limit the present disclosure.

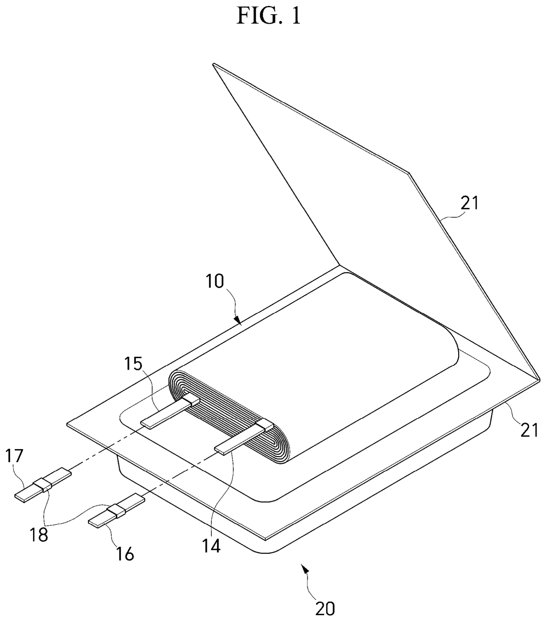

FIG. 1 schematically shows a pouch-type secondary battery.

The pouch-type secondary battery includes an electrode assembly 10 and a pouch 20 that accommodates the electrode assembly 10.

The electrode assembly 10 is the same as that illustrated in FIG. 1. The first electrode tab 14 and the second electrode tab 15 of the electrode assembly 10 may be electrically connected to respective external first and second terminal leads 16 and 17 by welding. Each of the first terminal lead 16 and the second terminal lead 17 may be attached with a tab film 18 for insulation from the pouch 20.

The pouch 20 may be sealed by having sealing parts 21 at the edges thereof, for example frame-shaped sealing parts 21 extending around the periphery, come into contact with each other with accommodating the electrode assembly 10 therein, in which case the sealing may be achieved with the tab film 18 interposed between the sealing parts 21. The sealing parts 21 of the pouch 20 may each be made of a thermal fusion material that generally has weak adhesion to metal. Thus, it may be fused to the pouch 20 by interposing the thin tab film 18 between the sealing parts 21.

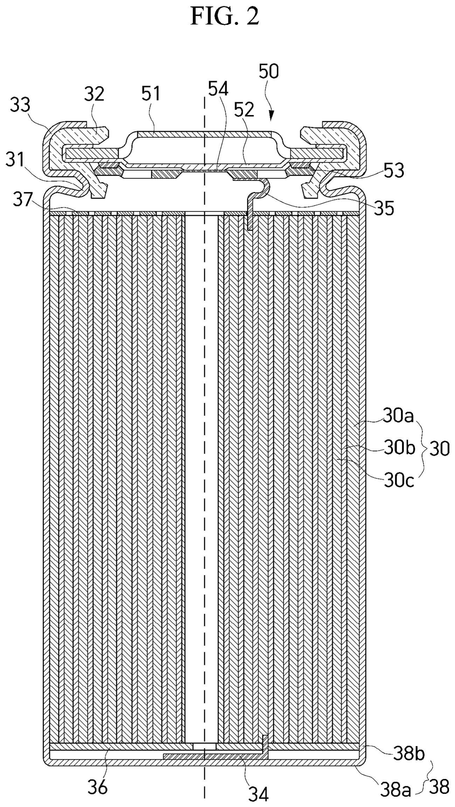

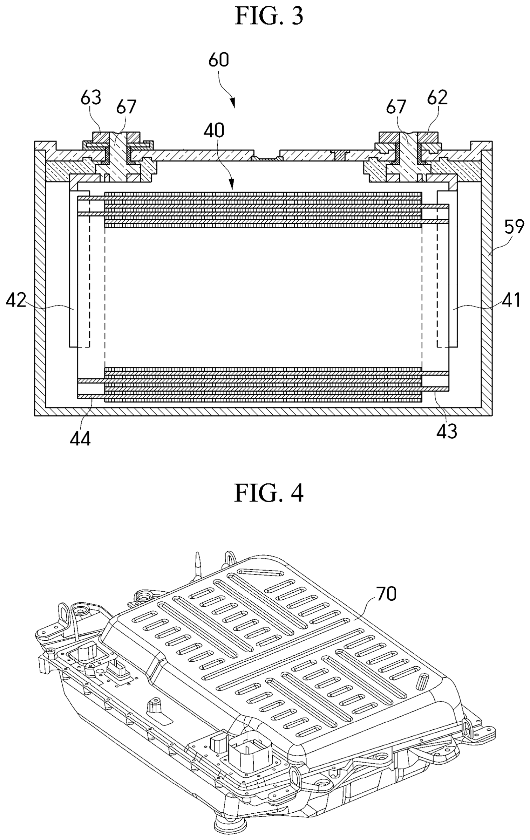

FIG. 2 is a cross-sectional view of a cylindrical secondary battery. As shown in FIG. 3, a secondary battery may include an electrode assembly 30, a case 38 accommodating the electrode assembly 30 and an electrolyte therein, a cap assembly 50 coupled to an opening of the case 38 to seal the case 38, and an insulating plate 37 positioned between the electrode assembly 30 and the cap assembly 50 inside the case 38.

The electrode assembly 30 may include a separator 30b and a first electrode 30c and a second electrode 30a positioned with the separator 30b interposed therebetween and may be wound in a jelly-roll shape.

The first electrode 30c includes a first substrate and a first active material layer on the first substrate. A first lead tab 35 may extend outwardly from a first uncoated portion of the first substrate at where the first active material layer is not located, and the first lead tab 35 may be electrically connected to the cap assembly 50.

The second electrode 30a includes a second substrate and a second active material layer on the second substrate. A second lead tab 34 may extend outwardly from a second uncoated portion of the second substrate at where the second active material layer is not located, and the second lead tab 34 may be electrically connected to the case 38. The first lead tab 35 and the second lead tab 34 may extend in opposite directions. For example, the first lead tab 35 and the second lead tab 34 max extend in opposite directions from opposite sides of the electrode assembly 30.

The first electrode 30c may act as a positive electrode. In such an embodiment, the first substrate may be made of, for example, an aluminum foil, and the first active material layer may include, for example, a transition metal oxide. The second electrode 30a may act as a negative electrode. In such an embodiment, the second substrate may be made of, for example, a copper foil or a nickel foil, and the second active material layer may include graphite, for example.

The separator 30b prevents a short circuit between the first electrode 30c and the second electrode 30a while allowing movement of lithium ions therebetween. The separator 32 may be made of, for example, a polyethylene film, a polypropylene film, a polyethylene-polypropylene film, or the like.

The case 38 accommodates the electrode assembly 30 and the electrolyte, and, together with the cap assembly 50, forms the external appearance of the battery. The case 38 may have a substantially cylindrical body portion 38b and a bottom portion 38a connected to one side of the body portion 38b. A beading part 31 (e.g., a bead) deformed inwardly may be formed in the body portion 38b, and a crimping part 33 (e.g., a crimp) bent inwardly may be formed at an open end of the body portion 38b.

The beading part 31 can reduce or prevent movement of the electrode assembly 30 inside the case 38 and can facilitate seating of the gasket 32 and the cap assembly 50. The crimping part 33 may firmly fix the cap assembly 50 by pressing the edge of the case 38 against the gasket 32. The case 38 may be formed of steel plated with nickel, composite material, etc.

The cap assembly 50 may be fixed to the inside of the crimping part 33 by a gasket 32 to seal the case 38. The cap assembly 50 may include a cap up (or upper cap) 51, a safety vent 52, a cap down (or lower cap) 53, an insulating member, and a sub plate 54 but is not limited thereto and may be modified in various ways.

The cap up 51 may be positioned at the uppermost part of the cap assembly 50. The cap up 51 may include a terminal part that protrudes upwardly and is connected to an external circuit, and an outlet for discharging gas may be arranged around the terminal part.

The safety vent 52 may be located under the cap up 51. The safety vent 52 may include a protrusion part that protrudes convexly downwardly and is connected to the sub plate 54, and at least one notch may be formed in the safety vent around the protrusion part.

When gas is generated due to overcharging or abnormal operation of the secondary battery, the protrusion part is deformed upwardly by the pressure and separates from the sub plate 54 while the safety vent 52 is cut along the notch. The cut safety vent 52 may prevent the secondary battery from exploding by allowing for the gas to be discharged to the outside.

The cap down 53 may be below the safety vent 52. The cap down 53 may have a first opening for exposing the protrusion part of the safety vent 52 and a second opening for gas discharge. The insulating member may be positioned between the safety vent 52 and the cap down 53 to insulate the safety vent 52 and the cap down 53.

The sub plate 54 may be under the cap down 53. The sub plate 54 may be fixed to a lower surface of the cap down 53 to block the first opening of the cap down 53, and the protrusion part of the safety vent 52 may be fixed to the sub plate 54. The first lead tab 35, which is drawn out from the electrode assembly 30, may be fixed to the sub plate 54. Accordingly, the cap up 51, the safety vent 52, the cap down 53, and the sub plate 54 may be electrically connected to the first electrode 30c of the electrode assembly 30.

The insulating plate 37 may be positioned to be in contact with the electrode assembly 30 below the beading part 31. The insulating plate 37 may have a tab opening through which the first lead tab 35 is drawn out. The cap assembly 50, which is electrically connected to the first electrode 30c by the first lead tab 35, may face the electrode assembly 30 with the insulating plate 37 interposed therebetween and may maintain a state of being insulated (e.g., electrically insulated) from the electrode assembly 30 by the insulating plate. Meanwhile, another insulating plate 36 may be included for insulation between the electrode assembly 30 and the bottom portion 38a of the case 38.

FIG. 3 shows the internal structure of a prismatic secondary battery and the coupling structure with the cap assembly 60.

An electrode assembly 40 may be formed by winding or stacking a stack of a first electrode plate, a separator, and a second electrode plate, which are formed as thin plates or films. When the electrode assembly 40 is a wound stack, a winding axis may be parallel to the longitudinal direction of the case 38. In some other embodiments, the electrode assembly 40 is a stack type rather than a winding type. The shape of the electrode assembly 40 is not limited in the present disclosure. In addition, the electrode assembly 40 may be a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the present disclosure. The first electrode plate of the electrode assembly may act as a negative electrode, and the second electrode plate may act as a positive electrode. Of course, the reverse is also possible.

The first electrode plate may be formed by applying a first electrode active material, such as graphite, carbon, or the like, to a first electrode current collector formed of a metal foil, such as copper, a copper alloy, nickel, a nickel alloy, or the like. The first electrode tab 43 may act as a current flow path between the first electrode plate and the first current collector 41. In some embodiments, when the first electrode plate is manufactured, the first electrode tab 43 is formed by being cut in advance to protrude to one side of the electrode assembly 40, or the first electrode tab 43 protrudes to one side of the electrode assembly 40 more than (e.g., farther than or beyond) the separator without being separately cut.

The second electrode plate may be formed by applying a second electrode active material, such as a transition metal oxide, on a second electrode current collector 42 formed of a metal foil, such as aluminum or an aluminum alloy, and the second electrode plate may include a second electrode tab 44 (or a second uncoated portion) that is a region to which the second electrode active material is not applied. The second electrode tab 44 may act as a current flow path between the second electrode plate and the second current collector 42. In some embodiments, the second electrode tab 44 may be formed by being cut in advance to protrude to the other side (e.g., the opposite side) of the electrode assembly 30 when the second electrode plate is manufactured, or the second electrode plate may protrude to the other side of the electrode assembly more than (e.g., farther than or beyond) the separator without being separately cut. In other words, the first electrode tab 43 and the second electrode tab 44 may protrude from opposite sides of the electrode assembly 30.

The separator prevents or substantially reduces instances of a short circuit between the first electrode and the second electrode while allowing movement of lithium ions therebetween. The separator may be made of, for example, a polyethylene film, a polypropylene film, a polyethylene-polypropylene film, or the like.

In some embodiments, the electrode assembly 40 is accommodated in the case 38 along with an electrolyte.

In the electrode assembly 40, the first current collector 41 and the second current collector 42 may be welded and connected to the first electrode tab 43 extending from the first electrode plate and the second electrode tab 44 extending from the second electrode plate, respectively.

The first current collector 41 and the second current collector 42 are connected to the first terminal 62 and the second terminal 63 through connection members 67, respectively. In some embodiments, the connection members 67 may each have an outer peripheral surface that is threaded, and may be fastened to the first terminal 62 and the second terminal 63 by screwing. However, the present disclosure is not limited thereto. For example, the connection members 67 may also be coupled to the first terminal 62 and the second terminal 63 by riveting or welding.

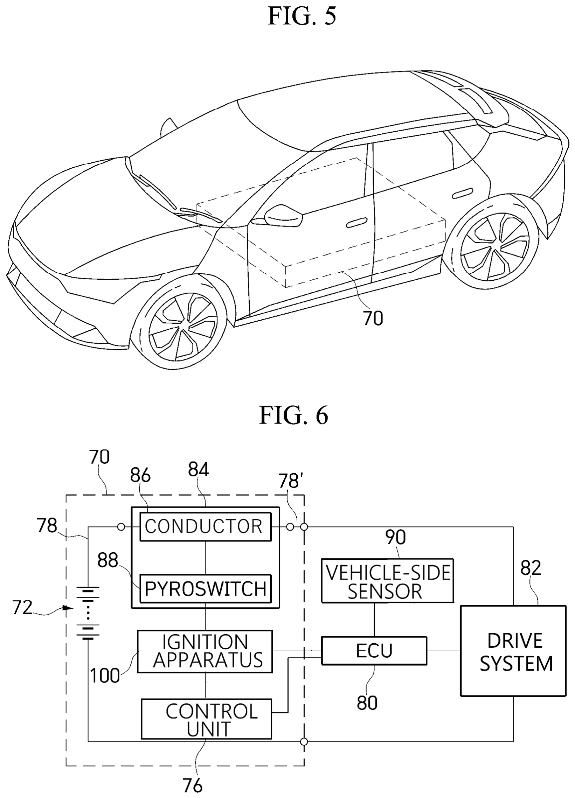

FIG. 4 is an exemplary view of a secondary battery module/pack for arranging secondary batteries and being applied to applications (e.g., energy storage systems (ESSs), vehicles, etc.), and FIG. 5 shows a secondary battery module/pack mounted in a vehicle.

A secondary battery module/pack 70 of FIG. 4 may be manufactured to obtain desired voltage and current specifications by arranging and connecting a plurality of cells in a lateral direction and/or in a longitudinal direction.

The secondary battery module/pack 70 may include or be linked to a battery management system (BMS). The BMS measures voltages (V), currents (I), temperatures (T), and the like of batteries installed in the electric vehicles or the energy storage system through sensors and identifies them in advance to control the batteries to exhibit optimal performance. The BMS may include a detection device, a balancing device, and a control device.

The detection device may detect a state of a battery (e.g., voltage, current, temperature, etc.) to output state information indicating the state of the battery. The detection device may detect the voltage of each cell constituting the battery or of each battery module. The detection device may detect current flowing through each battery module constituting the battery module or the battery pack. The detection device may also detect the temperature of a cell and/or module on at least one point of the battery and/or an ambient temperature.

The balancing device may perform a balancing operation of a battery module and/or cells constituting the battery module. The control device may receive state information (e.g., voltage, current, temperature, etc.) of the battery module from the detection device.

The control device may monitor and calculate the state of the battery module (e.g., voltage, current, temperature, state of charge (SOC), life span (state of health (SOH)), etc.) on the basis of the state information received from the detection device. In addition, based on the state monitoring results, the control device may perform control functions (e.g. temperature control, balancing control, and charging/discharging control), protection functions (e.g. over-discharge, over-charge, and over-current prevention, short circuit, fire extinguishing functions, and the like), or the like. In addition, the control device may perform a wired or wireless communication function with an external device of the battery pack (e.g., a higher level controller or vehicle, charger, power conversion system, etc.).

FIG. 6 is a block diagram showing a vehicle including a battery system according to embodiments of the present disclosure.

A configuration of FIG. 6 may be applied to other technical fields in which secondary batteries may be applied, such as ESSs, uninterruptible power supplies (UPSs), etc., other than vehicles.

The vehicle as shown may roughly include a battery system 70, an electronic control unit (ECU) 80, and a drive system 82. The drive system 82 may include a motor, an inverter, etc.

The shown battery system 70 may include a battery module 72, a pyrofuse 84, an ignition apparatus 100, and a control unit 76.

A plurality of battery cells may be connected in series and/or in parallel to the battery module 72. Here, the type of cells constituting the battery module 72 is not particularly limited, and lithium ion batteries, lithium polymer batteries, nickel cadmium batteries, nickel hydrogen batteries, nickel zinc batteries, etc., may be applied.

The control unit 76 may perform monitoring, control, and/or setting of the battery module 72 and the pyrofuse 84. The control unit 76 may be a portion of the BMS.

The pyrofuse 84 may be positioned on (or in) charge and discharge paths 78 and 78' of the battery module 72 and may perform a protective operation for the battery module 72. The pyrofuse 84 may include a conductor 86 (or a fuse) that directly connects the charge and discharge paths 78 and 78', an explosive (not shown) that explodes to cut the conductor, and a pyroswitch 88 for igniting the explosive to initiate an explosion. A battery disconnection switch product (model name: PSS-4) of Autoliv may be used as the pyrofuse 84, but the present specification is not limited to this product. The pyrofuse 84 may be a safety device using a pyrotechnic charge to rapidly and permanently disconnect a high-voltage circuit during faults like short circuits or crashes and may ensure immediate electrical isolation. The pyrofuse 84 may also be referred to as a pyrotechnic disconnect.

The ignition apparatus 100 may operate the pyroswitch 88 and receive an operating signal from the control unit 76 or an operating signal from the ECU 80 to operate the pyroswitch 88.

The control unit 76 may provide the ignition apparatus 100 with a signal for monitoring a state of the pyroswitch 88 and a signal for starting ignition to the ignition apparatus 100 and receive a state detection signal of the pyroswitch 88 from the ignition apparatus 100. In addition, the control unit 76 may receive a vehicle collision signal (e.g., an airbag activation signal) from the ECU 80 and provide the vehicle collision signal to the pyroswitch 88. The vehicle collision signal from the ECU 80 may be generated based on a signal detected by a sensor 90 installed in the vehicle. The control unit 76 may be implemented as an MCU, but is not limited thereto.

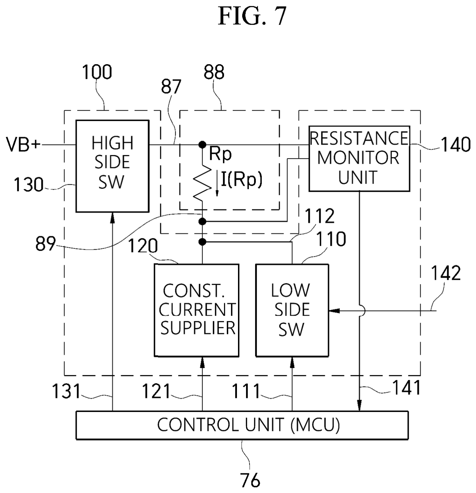

FIG. 7 is a schematic configuration view of the ignition apparatus 100 according to some embodiments of the present disclosure. The ignition apparatus 100 is an apparatus for operating the pyroswitch 88 to cause an explosion and cut the conductor 86 as described herein.

The pyroswitch 88 includes an internal resistance Rp, and the internal resistance may vary. Here, a first stage of the internal resistance Rp is referred to as a high side 87 to which an operating voltage VB+ is applied, and a second stage thereof is referred to as a low side 89 to which the ground is connected. The operating voltage VB+ applied to the high side 87 may be received from some of the cells of the battery module 72 shown in FIG. 6. To ignite the explosion device inside the pyrofuse 84 and cut the conductor 86, a current of several amperes (e.g., about 1.2 A or more than 1.2 A, about 1.5 A or more than 1.5 A, or about 2 A or more than 2 A) needs to be supplied to the pyroswitch 88. In addition, to monitor whether the state of the pyroswitch 88 is normal, a diagnostic current (e.g., about 100 mA) may be periodically applied to the pyroswitch 88 to check the internal resistance Rp value.

A low side switch 110 is connected to the low side 89 of the pyroswitch 88 to connect or disconnect the ground and the internal resistance Rp. The low side switch 110 receives an ignition signal 111 from the control unit 76 or an external ignition signal (e.g., a vehicle collision signal) 142 and outputs an ignition start signal 112. The ignition start signal 112 is transmitted to the pyroswitch 88 to ignite the explosive device and detonate the conductor 86 to disconnect the charge and discharge paths 78 and 78'. Due to such a function, the low side switch 110 may be referred to as an ignition part.

A constant current supplier 120 is also connected to the low side 89 of the pyroswitch 88. The constant current supplier 120 may supply a constant diagnostic current to the pyroswitch 88. That is, the constant current supplier 120 may limitedly supply a current so that a constant current (e.g., 100 mA) always flows within the operating voltage range (e.g., 6 to 16 V) of the pyroswitch 88 while performing diagnosis to check whether the pyroswitch 88 is in a normal state. The constant current supplier 120 may be configured to receive a monitoring enable signal 121 from the control unit 76 so that I(Rp) becomes a constant current of a predetermined amount.

A high side switch 130 is connected to the high side 87 of the pyroswitch 88. The high side switch 130 may be always operated by the control unit 76 and may turn off the operating voltage VB+ in response to the diagnostic signal 131 activated by the control unit 76 in order to check whether the pyroswitch 88 is in an abnormal state.

A resistance monitoring unit 140 transmits a voltage difference across the internal resistance Rp of the pyroswitch 88 as a state detection signal 141 to the control unit 76 to monitor the state of the pyroswitch 88. When the resistance value of the internal resistance Rp varies, an output value of the resistance monitoring unit 140 varies so that the state of the internal resistance Rp may be checked.

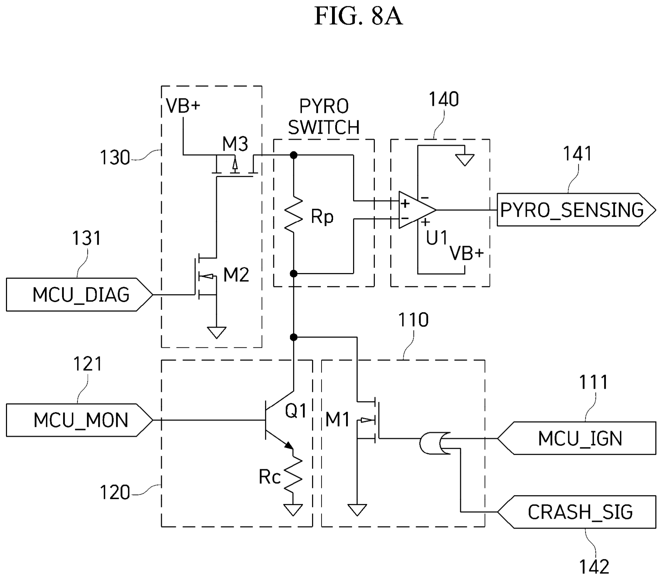

FIG. 8A shows each part of the ignition apparatus 100 shown in FIG. 7 in more detail.

The low side switch or ignition unit 110 may include a switch M1 that is turned on/off by one of the ignition signal 111, that is, an "MCU_IGN" signal, from the control unit 76 or the external ignition signal (e.g., the vehicle collision signal) 142, that is, a "CRASH_SIG" signal. When M1 is turned on, the internal resistance Rp is connected to the ground so that the current I(Rp) flowing in the internal resistance Rp becomes greater than a cutting threshold current value of the conductor 86, thereby disconnecting a portion between the charge/discharge path 78 and 78' connected to the conductor 86.

The constant current supplier 120 may include a switch Q1 that is turned on/off by receiving the monitoring enable signal 121, that is, an "MCU_MON" signal, from the control unit 76 and a current-limiting resistance Rc. When a high-state "MCU_MON" signal is applied from the control unit 76, the switch Q1 operates as a buffer so that constant voltage is always applied to the resistance Rc through a base-emitter, and a constant current corresponding to a resistance value of Rc flows through the internal resistance Rp.

In this way, in a state in which the constant current flows through the internal resistance Rp by the constant current supplier 120, the resistance monitoring unit 140 may use an OP amplifier U1 to detect the voltage difference across the internal resistance Rp of the pyroswitch 88. The OP amplifier U1 amplifies the voltage difference across the internal resistance Rp and outputs the state detection signal 141, that is, a "PYRO_SENSING" signal, to the control unit 76. The control unit 76 may receive the "PYRO_SENSING" signal and monitor the state of the pyroswitch 88.

The high side switch 130 includes a switch M3 for supplying the operating voltage VB+ to the pyroswitch 88. The operating voltage supply switch M3 may be turned off when the diagnostic signal 131, that is, an "MCU_DIAG" signal, from the control unit 76 is activated to check whether the pyroswitch 88 is in an abnormal state. That is, the control unit 76 blocks the operating voltage VB+ with M3 and checks whether the pyroswitch 88 is in an abnormal state. A switch M2, which is turned on/off by the "MCU_DIAG" signal, may be used to turn on/off the operating voltage supply switch M3. As an additional function, the high side switch 130 may protect the system by turning off the switch M3 when a current detector (not shown) detects a short of an external power line (e.g., a front-end line 78 (see FIG. 6) of the pyrofuse 84 from an output terminal of the M3).

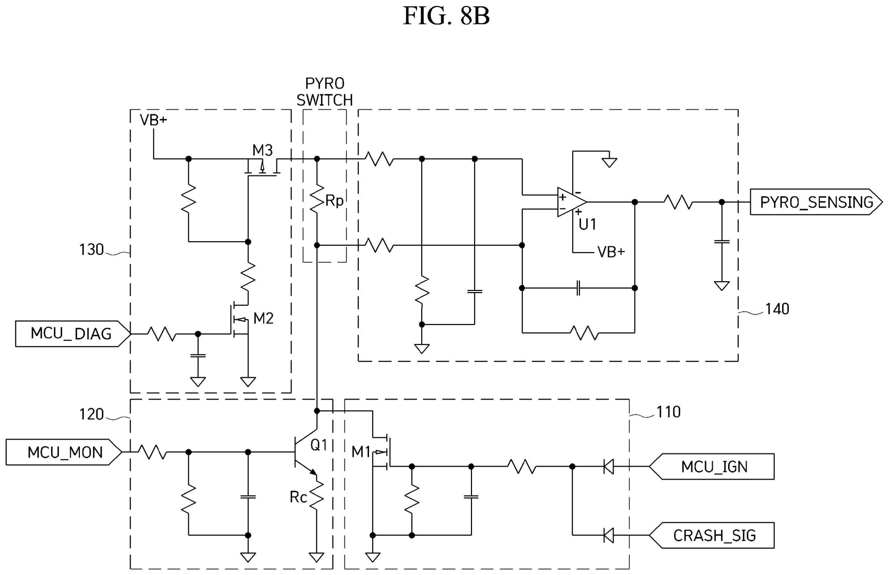

FIG. 8B is an exemplary circuit diagram implementing the configuration shown in FIG. 8A. FIG. 8B shows switch elements constituting each component and related passive elements.

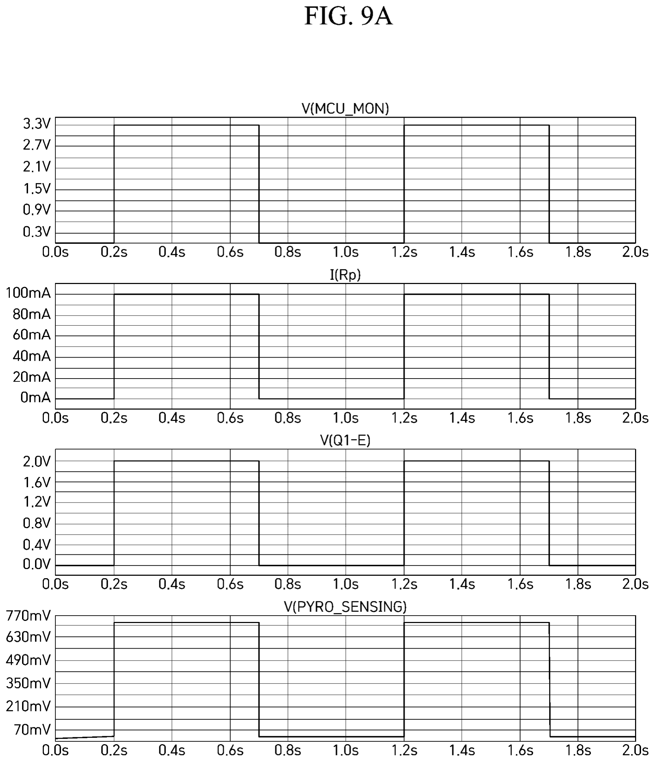

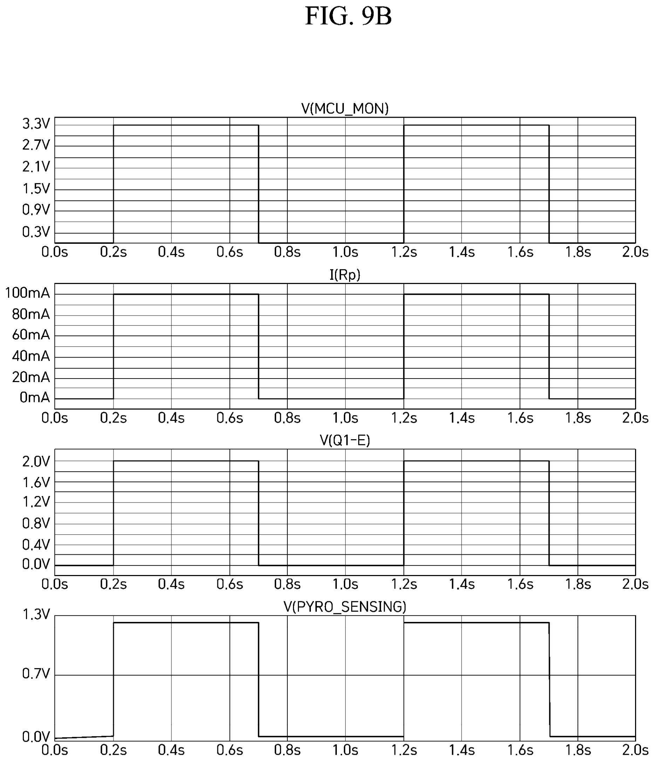

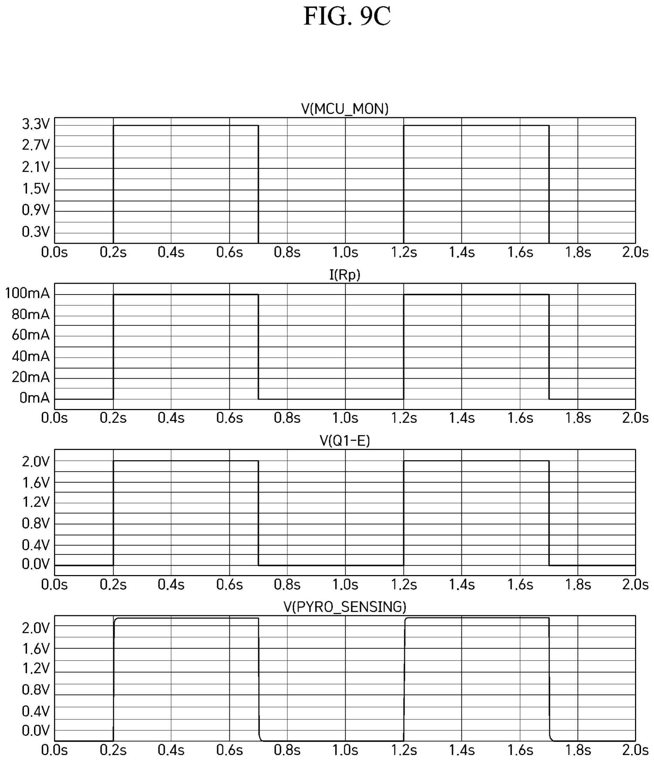

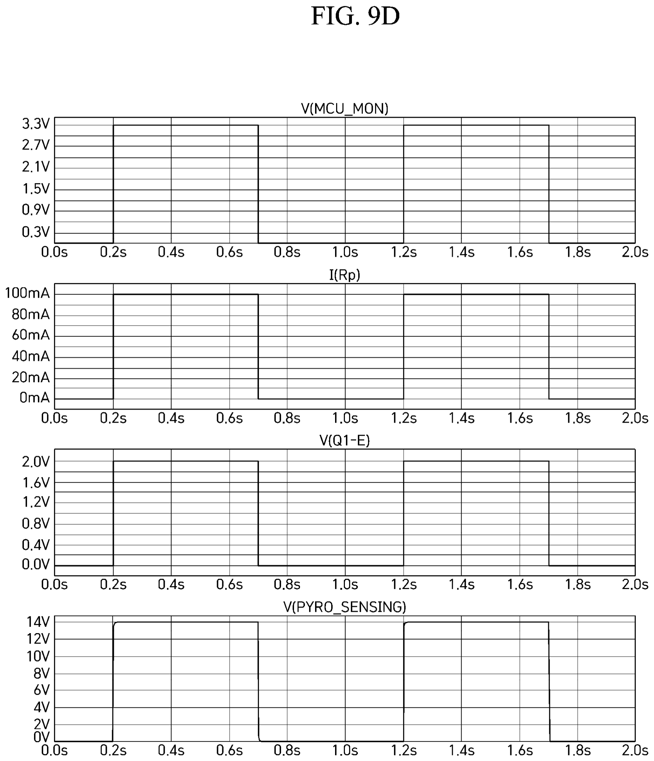

FIGS. 9A to 9D show a test simulation result of the pyroswitch ignition apparatus (100) according to the present disclosure. FIG. 9A shows a voltage of the monitoring enable signal "MCU_MON" applied to the constant current supplier 120 when the internal resistance Rp value of the pyroswitch 88 is 1 Ω, the current I(Rp) of the internal resistance, an emitter voltage (V(Q1-E) of FIGS. 9A to 10) of the switch Q1 of the constant current supplier 120 of FIGS. 8A and 8B, and a voltage of the state detection signal "PYRO_SENSING" of the resistance monitoring unit 140, FIG. 9B shows the same items when Rp=1.7 Ω, FIG. 9C shows the same items when Rp=3 Ω, and FIG. 9D shows the same items when Rp=20 Ω.

As a result of the simulation, it is verified that when the high side switch 130 is turned on and then the MCU_MON signal is turned on/off, even when the resistance value of the internal resistance Rp of the pyroswitch 88 changes, the constant voltage (V(Q1-E) shown in FIGS. 9A to 10) is always applied to Rc of the Q1 emitter terminal, and thus the constant current I(Rp) of the same size always flows through the internal resistance Rp. Specifically, this means that since the MCU_MON voltage is always applied with the same value (e.g., 3.3 V), the voltage V(Q1-E) applied to the emitter terminal of Q1 is always the same (e.g., 2 V), and thus, the value of the current flowing in Rp always flows as the same constant current (100 mA) regardless of the input voltage VB+ according to the resistance value (e.g., 2 Ohm) of Rc.

In addition, it is verified that the magnitude of the output value PYRO_SENSING of the resistance monitoring unit 140 changes as the resistance value of the internal resistance Rp changes, thereby enabling monitoring of the internal resistance. This result shows that since the source voltage of the switch Q1 of the constant current supplier 120 is always the same, when the operating voltage VB+ changes, the value of the current flowing in Rp is always the same.

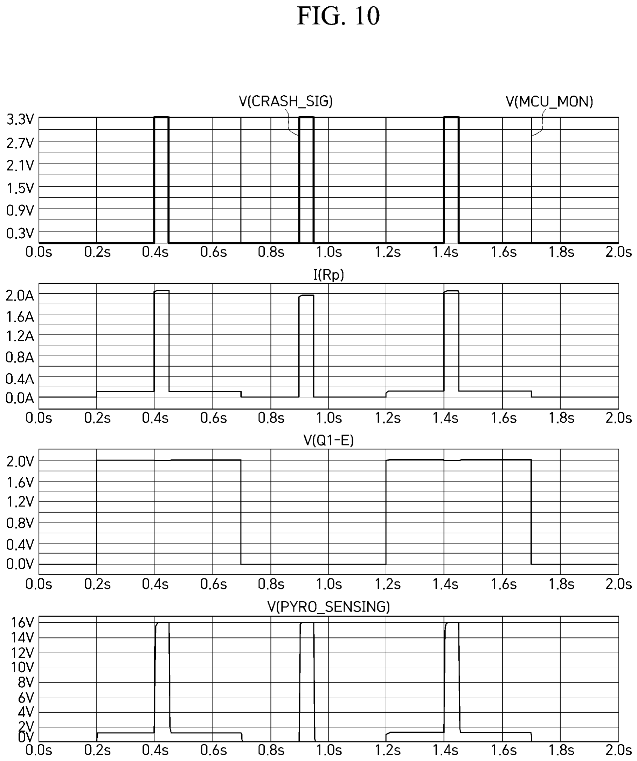

FIG. 10 shows a result of simulating the operation of the ignition part of the pyroswitch ignition apparatus 100, that is, the low side switch 110 of the pyroswitch ignition apparatus 100 according to the present disclosure.

It is verified that regardless of whether the switch of the constant current supplier 120 is turned on/off, when the CRASH_SIG signal 142 or the MCU_IGN signal 111 is applied to the low side switch 110, a high current (set as 2 A in FIG. 10) flows through the internal resistance Rp, causing the pyroswitch 88 to operate and ignite the pyrofuse.

According to the present disclosure, by supplying a constant current to a pyrofuse using a constant current supplier connected to a low side of a pyroswitch and monitoring the pyrofuse by detecting a change in internal resistance value, an ignition apparatus with a low cost and easy controllability can be implemented as a compact hardware circuit. Specifically, an ignition operation of the pyrofuse can be performed by various ignition sources such as an external collision signal, a short current signal, a microcontroller unit (MCU) ignition signal of a control unit, etc., and an ignition device circuit can be protected through the diagnosis of the pyrofuse as well as the ignition operation, which is the main function thereof.

Although the present disclosure has been described herein with respect to embodiments thereof, the present disclosure is not limited thereto. Various modifications and variations can be made thereto by those skilled in the art within the present disclosure as defined by the appended claims.

## Claims

1. A pyrofuse ignition apparatus (100) comprising:
a pyroswitch (88) comprising a high side (87) to which an operating voltage is applied, a low side (89) to which a ground is connected, and an internal resistance between the high side (87) and the low side (89);
a low side switch (110) that outputs an ignition start signal (112) to the low side (89) of the pyroswitch (88);
a constant current supplier (120) that is connected to the low side (89) of the pyroswitch (88) and supplies a constant current to the internal resistance of the pyroswitch (88);
a high side switch (130) configured to turn off the operating voltage applied to the high side (87) of the pyroswitch (88) when diagnosing the pyroswitch (88); and
a resistance monitoring unit (140) configured to monitor a voltage difference across the internal resistance of the pyroswitch (88).

2. The pyrofuse ignition apparatus (100) as claimed in claim 1, wherein the low side switch (110) comprises a first switch configured to connect or disconnect the low side (89) to or from the ground by an ignition signal (111) received from the outside.

3. The pyrofuse ignition apparatus (100) as claimed in claim 1 or claim 2, wherein the constant current supplier (120) comprises a second switch that is turned on/off by a monitoring enable signal (121) received from the outside, and a current-limiting resistance.

4. The pyrofuse ignition apparatus (100) as claimed in one of the preceding claims, wherein the resistance monitoring unit (140) comprises an OP amplifier configured to amplify the voltage difference across the internal resistance of the pyroswitch (88) in a state in which the constant current flows through the internal resistance of the pyroswitch (88) by the constant current supplier (140).

5. The pyrofuse ignition apparatus (100) as claimed in one of the preceding claims, wherein the high side switch (130) comprises a third switch that is turned on to always supply the operating voltage to the pyroswitch (88) and is turned off when a diagnostic signal (131) received from the outside is activated.

6. The pyrofuse ignition apparatus (100) as claimed in claim 5, wherein the high side switch (130) further comprises a fourth switch that is turned on or off by an external signal to turn on or off the third switch.

7. A battery system (70) comprising:
a battery module (72) comprising a plurality of battery cells;
a pyroswitch (88) configured to block a charge/discharge path of the battery module (72);
an ignition apparatus (100) configured to operate the pyroswitch (88); and
a control unit (76) configured to provide the ignition apparatus (100) with a signal for monitoring a state of the pyroswitch (88) and a signal for initiating ignition and receive a state detection signal (141) of the pyroswitch (88) from the ignition apparatus (100).

8. The battery system (70) as claimed in claim 7, wherein the pyroswitch (88) comprises a high side (87) to which an operating voltage is applied, a low side (89) to which a ground is connected, and an internal resistance between the high side (87) and the low side (89), and wherein
the ignition apparatus (100) comprises:
a low side switch (110) that outputs an ignition start signal (112) to the low side (89) of the pyroswitch (88);
a constant current supplier (120) that is connected to the low side (89) of the pyroswitch (88) and supplies a constant current to the internal resistance of the pyroswitch (88);
a high side switch (130) configured to turn off an operating voltage applied to the high side (87) of the pyroswitch (88) when diagnosing the pyroswitch (88); and
a resistance monitoring unit (140) configured to monitor a voltage difference across the internal resistance of the pyroswitch (88).

9. The battery system (70) as claimed in claim 7 or claim 8, wherein the low side switch (110) comprises a first switch configured to connect or disconnect the low side (89) to or from the ground by an ignition signal (111) received from the control unit (76).

10. The battery system (70) as claimed in one of claims 7 through 9, wherein the constant current supplier (120) comprises a second switch that is turned on/off by a monitoring enable signal received from the control unit (76), and a current-limiting resistance.

11. The battery system (76) as claimed in one of claims 7 through 10, wherein the resistance monitoring unit (140) comprises an OP amplifier configured to amplify the voltage difference across the internal resistance of the pyroswitch (88) in a state in which the constant current flows through the internal resistance of the pyroswitch (88) by the constant current supplier (140).

12. The battery system (70) as claimed in one of claims 7 through 11, wherein the high side switch (130) comprises a third switch that is turned on to always supply the operating voltage to the pyroswitch (88) and is turned off when a diagnostic signal (131) received from the outside is activated.

13. The battery system (70) as claimed in claim 12, wherein the high side switch (130) further comprises a fourth switch that is turned on or off by a diagnostic signal (131) from the control unit (76) to turn on or off the third switch.

14. A method of manufacturing a pyrofuse ignition apparatus (100) including the steps of
providing a pyroswitch (88) having a high side (87) to which an operating voltage is applied, a low side (89) to which a ground is connected, and an internal resistance between the high side (87) and the low side (89),
providing a low side switch (110) that outputs an ignition start signal to the low side (89) of the pyroswitch (88),
providing a constant current supplier (120) that is connected to the low side (89) of the pyroswitch (88) and supplies a constant current to the internal resistance of the pyroswitch (88),
providing a high side switch (130) configured to turn off an operating voltage applied to the high side (87) of the pyroswitch (88) when diagnosing the pyroswitch (88), and
providing a resistance monitoring unit (140) configured to monitor a voltage difference across the internal resistance of the pyroswitch (88).

15. The method as claimed in claim 14, wherein the low side switch (110) comprises a first switch configured to connect or disconnect the low side (89) to or from the ground by an ignition signal (111) received from the outside.
